# DEMANDE DE BREVET EUROPEEN

(11) **EP 1 489 471 A1**
(43) Date de publication de la demande: **22.12.2004**
(21) Numéro de dépôt: 03013793.9
(22) Date de dépôt: 18.06.2003
(51) Int. Cl.: G04G 1/00, H01Q 1/27

(54) **Connexion de masse d'une plaquette de circuit imprimé dans un instrument électronique du type montre-bracelet**

(71) Demandeur: ASULAB S.A., 2074 Marin (CH)
(72) Inventeur: Zellweger, Emil, 4514 Lommiswil (DE); Etienne, Jean-Daniel, 2206 Les Geneveys-sur-Coffrane (DE); Ferri, Yvan, 1003 Lausanne (CH)
(74) Mandataire: Ravenel, Thierry Gérard Louis

(57) **Abrégé**

Il est décrit un instrument électronique porté au poignet comprenant une boîte (2) dont une partie au moins (4) est électriquement conductrice et dans laquelle sont notamment logés un module électronique (6) comprenant une plaquette de circuit imprimé (60) et une source d'énergie électrique (10) pour alimenter le module électronique. La plaquette de circuit imprimé (60) présente, en périphérie, une zone de contact mécanique avec la partie électriquement conductrice (4) de la boîte (2), et comporte une piste conductrice (65) s'étendant en périphérie de la plaquette de circuit imprimé, sur la zone de contact mécanique, et établissant un contact électrique avec la partie électriquement conductrice (4) de la boîte (2). Il est également décrit un tel instrument électronique comprenant par ailleurs une antenne (20) munie d'un plan de masse (22) où la piste conductrice (65) connecte électriquement ce plan de masse (22) à la partie électriquement conductrice (4) de la boîte (2) afin d'accroître la sensibilité de réception de l'antenne (20).

## Description

### DOMAINE TECHNIQUE

La présente invention concerne de manière générale la connexion électrique d'un module électronique dans un instrument portable. Plus spécifiquement, la présente invention concerne un instrument électronique porté au poignet comprenant une boîte dont une partie au moins est électriquement conductrice et dans laquelle sont notamment logés un module électronique comprenant une plaquette de circuit imprimé et une source d'énergie électrique pour alimenter le module électronique. Selon une variante spécifique, l'invention porte sur un tel instrument électronique comprenant par ailleurs une antenne munie d'un plan de masse.

### ARRIÈRE-PLAN TECHNOLOGIQUE

Des instruments électroniques portés au poignet se présentant notamment sous une forme analogue à celle d'une montre-bracelet sont déjà connus. Des exemples spécifiques de tels instruments électroniques répondant à la définition susmentionnée sont également connus.

Le document EP 1 274 150 A1 présente par exemple un instrument électronique portable pouvant prendre la forme d'une montre-bracelet et dont une partie de la boîte peut être réalisée en un matériau métallique électriquement conducteur, cet instrument électronique comprenant par ailleurs une antenne pour la réception de signaux de positionnement par satellites. Selon cette solution, le module électronique ne repose pas directement dans la partie électriquement conductrice de la boîte mais à l'intérieur d'un ensemble réalisé en un matériau plastique, l'alimentation électrique du module électronique par la source d'énergie électrique étant réalisée classiquement par l'intermédiaire de brides ou de lames de contact conductrices. On notera par ailleurs que l'antenne (une antenne microruban - ou antenne patch - comprenant un élément radiant séparé d'un plan de masse par un diélectrique) repose sur un élément formant lunette ajusté sur la boîte et réalisé en un matériau diélectrique.

Les articles intitulés "GPS Watch - Une montre à quartz analogique équipée d'un récepteur GPS à très faible consommation" (Congrès Européen de Chronométrie, CEC 2000, Session 7, Communication 19, Genève, 28 et 29 septembre 2000) et "GPS Watch - An Analogue Watch Including a Very Low Power GPS Receiver" (ION GPS 2000 Conference, Salt Lake City, UT, USA, September 19-22, 2000) au nom de P.-A. Farine et consorts, Asulab S.A., décrivent également un instrument électronique se présentant sous la forme d'une montre-bracelet comprenant une boîte dans laquelle sont logés une source d'énergie électrique, un module électronique portant notamment une antenne microruban et un récepteur de positionnement par satellites, ainsi qu'un dispositif d'affichage analogique et digital. Une partie de la boîte, en l'occurrence un fond-carrure, peut également être réalisée en un matériau métallique électriquement conducteur, une lunette non métallique étant toutefois ajustée sur la partie supérieure de l'instrument au dessus de l'antenne. A l'image de la solution décrite dans le document EP 1 274 150 A1 susmentionné, l'alimentation du module électronique par la source d'énergie électrique est assurée par le biais de brides ou lames de contact conductrices. Selon cette solution, il est à noter que l'antenne microruban repose directement sur la plaquette de circuit imprimé du module électronique où est réalisé son plan de masse.

Pour compléter cet énoncé de l'état de la technique, on peut encore citer le document EP 1 134 837 A1 qui décrit un instrument électronique portable comprenant une antenne microruban dite en L ou F inversé ("Inverted L Antenna" ou "Inverted F Antenna) en raison de son profil particulier. Le plan de masse de cette antenne est réalisé sur la face supérieure de la plaquette de circuit imprimé du module électronique. Dans la mesure où les parties latérale et supérieure de la boîte sont réalisées d'une pièce comme illustré dans ce document, la configuration de l'instrument rend obligatoire l'utilisation d'un matériau diélectrique pour réaliser la boîte dans laquelle est logé le module électronique. L'alimentation du module électronique par la source d'énergie électrique est à nouveau assurée par des brides ou lames de contact conductrices. Il convient de relever encore que l'instrument électronique présente un fond en matériau métallique qui est relié électriquement à un potentiel électrique déterminé, en l'occurrence le potentiel positif de la source d'énergie électrique. Il est mentionné que cette connexion électrique présente l'avantage de permettre d'accroître la superficie du plan de masse de l'antenne, ce qui se traduit par une sensibilité accrue de l'antenne.

Dans les exemples mentionnés ci-dessus, il convient donc de constater que l'alimentation du module électronique par la source d'énergie électrique est classiquement réalisée par le biais d'un jeu de brides ou de lames de contact conductrices reliant électriquement les deux pôles électriques de la source d'énergie aux ensembles de pistes conductrices d'alimentation réalisés typiquement sur la plaquette de circuit imprimé du module électronique.

Lorsque l'on désire concevoir un instrument électronique du type susmentionné et l'équiper d'une boîte dont une partie au moins est électriquement conductrice, par exemple métallique, on sait qu'il est par ailleurs désirable de fixer le potentiel électrique de cette partie conductrice plutôt que de le laisser flottant. Le potentiel électrique de cette partie électriquement conductrice est donc souvent fixé par connexion électrique à l'un des pôles de la source d'énergie électrique, par exemple au potentiel formant masse ou à l'autre potentiel d'alimentation. Cette connexion électrique est réalisée soit par connexion directe de la partie concernée avec le pôle correspond de la source d'énergie ou à nouveau par l'intermédiaire de brides ou lames de contact conductrices. A titre d'exemple, le document EP 1 134 837 A1 ci-dessus mentionne que la connexion du fond métallique au pôle positif de la source d'énergie électrique est effectuée par le biais de lames de contact.

L'utilisation de brides ou lames de contact conductrices pour assurer la connexion électrique du module électronique et/ou d'une partie de la boîte à la source d'énergie électrique constitue souvent une contrainte, en particulier lors de l'assemblage de l'instrument portable. La présente invention vise à proposer une solution permettant de simplifier dans une certaine mesure la réalisation de ces connexions électriques ainsi que les opérations d'assemblage de l'instrument.

Dans le cadre d'une réalisation plus spécifique où l'instrument incorpore une antenne munie d'un plan de masse, on cherche par ailleurs à trouver une solution permettant d'accroître la sensibilité de l'antenne par élargissement de son plan de masse (à l'image de ce que propose le document EP 1 134 837) toutefois par le biais d'une connexion électrique simplifiée.

### RÉSUMÉ DE L'INVENTION

La présente invention a ainsi pour objet un instrument électronique portable dont les caractéristiques sont énoncées dans la revendication indépendante 1.

Ainsi, selon l'invention, la plaquette de circuit imprimé présente, en périphérie, une zone de contact mécanique avec la partie électriquement conductrice de la boîte et comporte une piste conductrice s'étendant en périphérie de la plaquette de circuit imprimé, sur la zone de contact mécanique, afin de permettre l'établissement d'un contact électrique avec la partie électriquement conductrice de la boîte.

Selon un mode de réalisation spécifique de l'invention où l'instrument comporte en outre une antenne munie d'un plan de masse, la piste conductrice s'étendant en périphérie de la plaquette de circuit imprimé connecte électriquement le plan de masse de l'antenne à la partie électriquement conductrice de la boîte. Cette connexion assure un élargissement du plan de masse de l'antenne et un accroissement de la sensibilité de réception de cette antenne.

Selon une variante particulièrement avantageuse, un ruban conducteur en matériau compressible (préférablement un élastomère conducteur) est interposé, sur la zone de contact mécanique, entre la partie électriquement conductrice de la boîte et la piste conductrice. Ce ruban conducteur est préférablement comprimé entre la piste conductrice et un épaulement ménagé sur la partie électriquement conductrice de la boîte. En outre, l'instrument peut comporter un élément de support exerçant un appui en plusieurs points de la périphérie de la plaquette de circuit imprimé où est comprimé le ruban conducteur, ceci afin de favoriser une bonne stabilité mécanique de l'ensemble ainsi qu'un bon contact électrique entre la partie conductrice de la boîte et le module électronique.

D'autres variantes avantageuses font l'objet des revendications dépendantes.

### BRÈVE DESCRIPTION DES DESSINS

D'autres caractéristiques et avantages de la présente invention apparaîtront plus clairement à la lecture de la description détaillée qui suit de modes de réalisation de l'invention donnés uniquement à titre d'exemples non limitatifs et illustrés par les dessins annexés où :
- la figure 1 montre une vue en plan globale d'un instrument électronique porté au poignet se présentant sous une forme analogue à celle d'une montre-bracelet et constituant un mode de réalisation de l'invention ;
- la figure 2 est une vue en coupe partielle de l'instrument électronique de la figure 1 selon la ligne de coupe A-A parallèle à l'axe 6h-12h de l'instrument ;
- la figure 3 est une vue agrandie de la coupe de la figure 2 au niveau de la zone de contact mécanique entre la périphérie de la plaquette de circuit imprimé et la boîte ;
- la figure 4 est une autre vue en coupe partielle de l'instrument électronique de la figure 1 selon la ligne de coupe B-B parallèle à l'axe 9h-3h de l'instrument ; et
- la figure 5 est une vue en plan de l'instrument électronique où la partie supérieure de cet instrument ainsi qu'une partie du dispositif d'affichage n'ont pas été représentés.

### MODES DE RÉALISATION

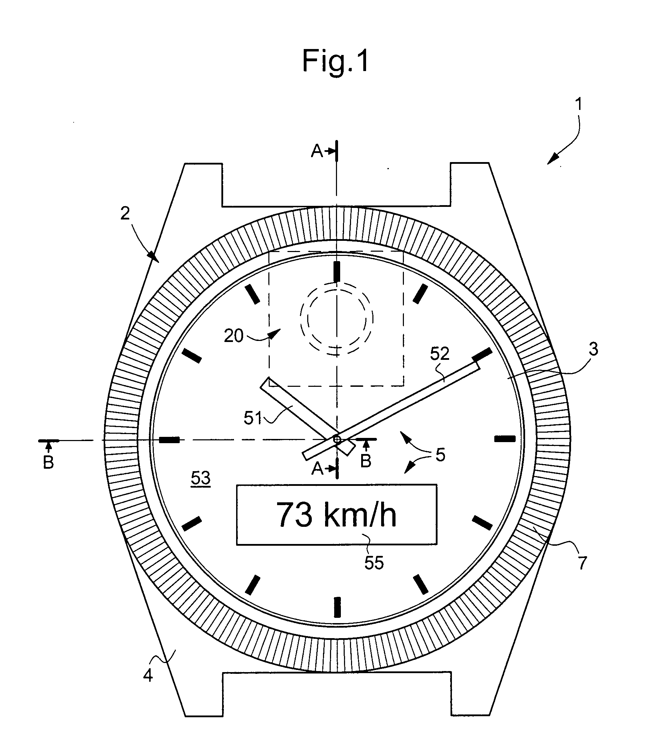

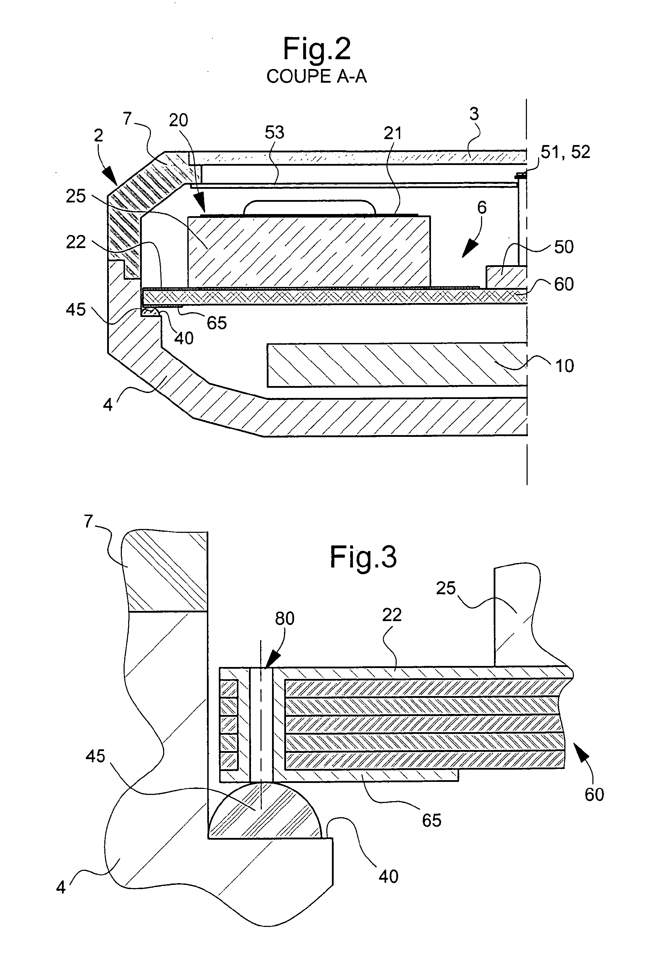

La figure 1 montre une vue en plan d'un instrument électronique, repéré globalement par la référence numérique 1, selon un premier mode de réalisation de l'invention. Cet instrument se présente avantageusement sous la forme d'une montre-bracelet et est notamment équipé d'une antenne 20 (représentée en traits interrompus sur la figure 1) reliée électriquement à un module électronique (référence 6 dans les figures 2 et 3) logé à l'intérieur de l'instrument électronique 1. Dans le cadre de ce mode de réalisation, l'antenne 20 est destinée à permettre la réception de signaux radiofréquences émis par une ou plusieurs sources d'émission éloignées. Plus particulièrement, cette antenne 20 est destinée à permettre la réception de signaux de positionnement et de navigation par satellites, tels les signaux GPS provenant du système de positionnement par satellites américain NAVSTAR ou d'autres signaux de positionnement provenant de systèmes analogues tels le système russe GLONASS ou le futur système européen de positionnement et de navigation par satellites GALILEO.

Il convient d'insister sur le fait que la présence d'une antenne dans l'instrument électronique 1 n'est pas une nécessité pour la mise en oeuvre de l'invention. On mentionnera toutefois que l'invention présente un avantage dans l'optique d'améliorer le fonctionnement de l'antenne comme on le verra plus loin.

L'instrument électronique 1 présente une allure générale analogue à celle d'une montre-bracelet classique et comporte, outre l'antenne 20, une boîte 2, un bracelet (non représenté) attaché à la boîte 2, une glace 3 sous laquelle est disposé un dispositif d'affichage 5 enfermé dans la boîte 2, et des organes de commande (non représentés). Le dispositif d'affichage 5 comporte, dans le cas d'espèce, un affichage analogique comprenant deux aiguilles 51, 52 se déplaçant en regard d'un cadran 53 (notamment pour permettre une indication classique de l'heure) complété par un affichage digital 55, par exemple à cristaux liquides. Du point de vue de l'affichage et de l'interface utilisateur, cet instrument électronique est comparable à celui décrit dans les deux articles de P.-A. Farine et consorts mentionnés dans l'énoncé de la technique ci-dessus. En tout état de cause, la configuration représentée dans les figures doit être considérée comme purement illustrative et non limitative.

La figure 2 montre une vue en coupe partielle de l'instrument électronique de la figure 1 prise selon la ligne de coupe A-A parallèle à l'axe 6h-12h et passant par le centre de l'instrument 1. On y retrouve notamment la boîte 2, la glace 3, le cadran 53 en regard duquel tournent les aiguilles 51, 52, et l'antenne 20 disposée sous le cadran 53. L'instrument électronique comporte en outre, comme illustré, un module électronique 6 comportant une plaquette de circuit imprimé 60 (préférablement une plaquette multicouche) sur laquelle sont montés les divers composants électroniques et électriques de l'instrument (dont un moteur désigné 50 avec ses axes pour l'entraînement des aiguilles 51, 52) ainsi qu'une source d'alimentation en énergie électrique 10 alimentant notamment le module électronique 6 et le dispositif d'affichage 5. Cette source d'alimentation en énergie électrique 10 peut être constituée d'une pile ou d'une batterie conventionnelle, d'un accumulateur rechargeable ou de toute autre source d'énergie électrique adéquate.

Comme illustré dans la figure 2, l'antenne 20 repose directement sur la face supérieure de la plaquette de circuit imprimé 60 du côte de la glace 3 et du dispositif d'affichage 5, sous le cadran 53. La boîte 2 est quant à elle formée en deux partie, une première formant un corps d'habillage ou fond-carrure 4, et une deuxième formant lunette 7 qui porte la glace 3 et qui est ajustée sur le corps d'habillage 4. Du fait de la disposition de l'antenne 20 à l'intérieur de la boîte 2 dans cet exemple, la lunette 7, le cadran 53 ainsi que les aiguilles 51, 52 qui couvrent en partie l'antenne 20 sont réalisés dans un matériau ne perturbant pour ainsi dire pas le fonctionnement de l'antenne, tel un matériau plastique (les aiguilles 51, 52 peuvent par ailleurs être amenées dans des positions angulaires où elles ne couvrent plus l'antenne). Le corps d'habillage 4 est quant à lui réalisé en un matériau électriquement conducteur, avantageusement en métal (par exemple en acier ou en aluminium), ou en un matériau de base recouvert d'une couche externe électriquement conductrice.

Dans l'illustration de la figure 2, on peut voir que la plaquette de circuit imprimé 60 présente en périphérie une zone de contact mécanique avec la partie électriquement conductrice de la boîte 2, à savoir avec le corps d'habillage 4 dans cet exemple. Plus spécifiquement, le corps d'habillage 4 comporte un épaulement 40 sur lequel vient reposer la plaquette de circuit imprimé 60 par sa périphérie.

Dans le mode de réalisation représenté dans les figures, l'antenne 20 est une antenne microruban (ou antenne patch) de forme essentiellement parallélépipédique comportant un élément radiant 21 séparé d'un plan de masse 22 par un diélectrique 25, par exemple en matériau céramique. Le volume de l'antenne 20 est typiquement de l'ordre de 13 x 13 x 4 mm³ approximativement. L'élément radiant 21 est formé d'un élément conducteur essentiellement rectangulaire reposant sur la partie supérieure du diélectrique 25. Cet élément radiant 21 est conventionnellement relié à l'électronique par le biais d'un conducteur (non représenté) traversant le diélectrique 25 pour être connecté à une piste correspondante sur la plaquette de circuit imprimé 60. Le plan de masse 22 de l'antenne est quant à lui formé d'une surface conductrice (par exemple une métallisation) apposée sur la face supérieure de la plaquette de circuit imprimé 60. La superficie du plan de masse 22 de l'antenne est typiquement plus importante que celle de l'élément radiant 21.

On cherche typiquement à maximiser la superficie du plan de masse 22, l'étendue de ce plan de masse 22 étant toutefois limitée par la présence des composants électriques et électroniques disposés au voisinage de l'antenne 20 sur le module électronique 6. Dans le cas d'espèce, le moteur 50 d'entraînement des aiguilles 51, 52 est disposé à proximité de l'antenne 20. En pratique, il n'est ainsi pas possible de réaliser un plan de masse d'une taille aussi grande que souhaité sans compromettre les dimensions de l'instrument électronique 1 dans son ensemble. Compte tenu de ces contraintes, on exploite préférablement une couche intermédiaire de la plaquette de circuit imprimé 60 multicouche pour y ménager une couche de masse additionnelle que l'on relie aux autres couches ainsi qu'au plan de masse 22 de l'antenne 20, par exemple par des trous métallisés.

La figure 3 est une vue agrandie de la coupe de la figure 2 au niveau de la zone de contact mécanique entre la périphérie de la plaquette de circuit imprimé 60 et la partie électriquement conductrice de la boîte 2. Sur cette vue, on a représenté une partie du plan de masse 22 de l'antenne 20 sur la face supérieure de la plaquette de circuit imprimé 60 ainsi qu'un trou métallisé 80 traversant les diverses couches (ici au nombre de six) de la plaquette de circuit imprimé 60. On mentionnera qu'une multitude de trous métallisés est ainsi réalisée sur la plaquette de circuit imprimé 60, non seulement pour assurer des connexions à la masse, mais également pour assurer des connexions électriques entres les composants électriques et électroniques et les diverses pistes du module électronique 6 qui sont ménagées dans les couches intermédiaires de la plaquette de circuit imprimé 60. Il convient de noter que la taille du trou métallisé 80 ainsi que l'épaisseur des couches intermédiaires de la plaquette de circuit imprimé 60 ou des couches conductrices ne sont pas représentées à l'échelle.

Comme illustré dans la figure 3, et reporté sur la figure 2, une piste conductrice désignée 65 est ménagée sur la face inférieure de la plaquette de circuit imprimé 60 et est reliée électriquement au plan de masse 22 de l'antenne 20 par l'intermédiaire de trous métallisés 80 (voire d'autres répartis sur le module électronique 6). Cette piste conductrice 65 est ménagée sur la périphérie de la plaquette de circuit imprimé 60 et est notamment localisée dans la zone de contact mécanique entre la plaquette de circuit imprimé 60 et l'épaulement 40 ménagé sur le corps d'habillage 4 de la boîte. Cette piste conductrice 65 s'étend préférablement sur essentiellement toute la périphérie de la plaquette de circuit imprimé 60, bien qu'il soit envisageable d'interrompre cette piste conductrice 65 en un ou plusieurs points de la périphérie. Ménager la piste 65 sur pratiquement toute la périphérie de la plaquette de circuit imprimé présente l'avantage d'améliorer la qualité du contact électrique avec la partie électriquement conductrice de la boîte 2. D'autre part, cette solution permet de participer à une amélioration du blindage des composants situés, dans cet exemple, sur la face inférieure du module électronique 6 (par souci de simplification, on a renoncé à représentés ces composants dans les figures).

Préférablement, comme illustré, un ruban électriquement conducteur 45 en matériau compressible est interposé sur la zone de contact mécanique entre la partie électriquement conductrice de la boîte 2 et la piste conductrice 65. Il est a priori envisageable de se passer de ce ruban conducteur 45. L'utilisation du ruban conducteur 45 est cependant préférable afin d'assurer une bonne qualité et une bonne tenue du contact électrique entre la piste 65 et le corps d'habillage conducteur 4. Le ruban conducteur 45 peut avantageusement être réalisé en un élastomère conducteur conformé en un joint interposé entre l'épaulement 40 et la plaquette de circuit imprimé 60 ou alternativement déposé directement sur l'épaulement 40 avant le montage du module électronique 6.

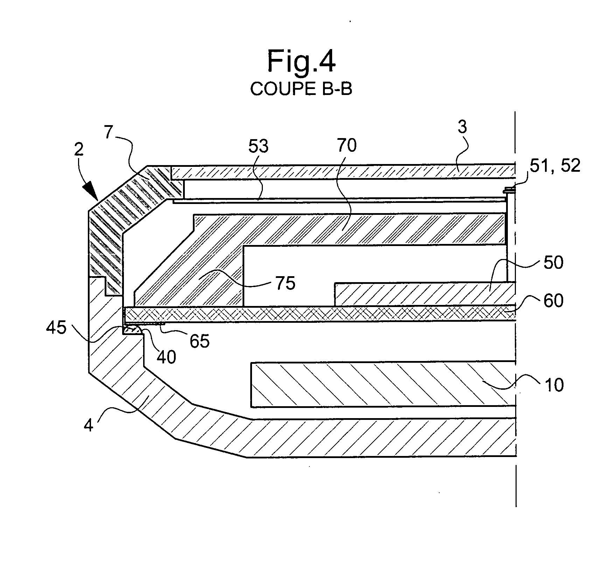

Pour améliorer encore la qualité et la tenue du contact mécanique et électrique entre le module électronique 6 et la partie conductrice de la boîte 2, il est encore préférable de prévoir un élément de support exerçant un appui en plusieurs points de la périphérie de la plaquette de circuit imprimé 60 où est comprimé le ruban électriquement conducteur 45. Comme illustré dans la figure 4, le mode de réalisation illustré comporte un tel élément de support désigné par la référence numérique 70 qui est placé sur la face supérieure de la plaquette de circuit imprimé 60 sous la lunette 7. Cet élément de support 70 comporte une base 75 qui vient en appui sur la périphérie de la plaquette de circuit imprimé 60 où est comprimé le ruban conducteur 45. Cette base 75 permet de rigidifier la périphérie de la plaquette de circuit imprimé 60 qui peut typiquement présenter une relativement faible épaisseur et donc une certaine élasticité.

L'élément de support 70 peut être simplement interposé entre le module électronique 6 et la lunette 7 et être ainsi plaqué contre le module électronique 6 ou être directement rendu solidaire du fond-carrure 4, par exemple par vissage. Alternativement, on comprendra encore que la lunette 7 pourrait être modifiée pour agir directement sur la périphérie de la plaquette de circuit imprimé 60.

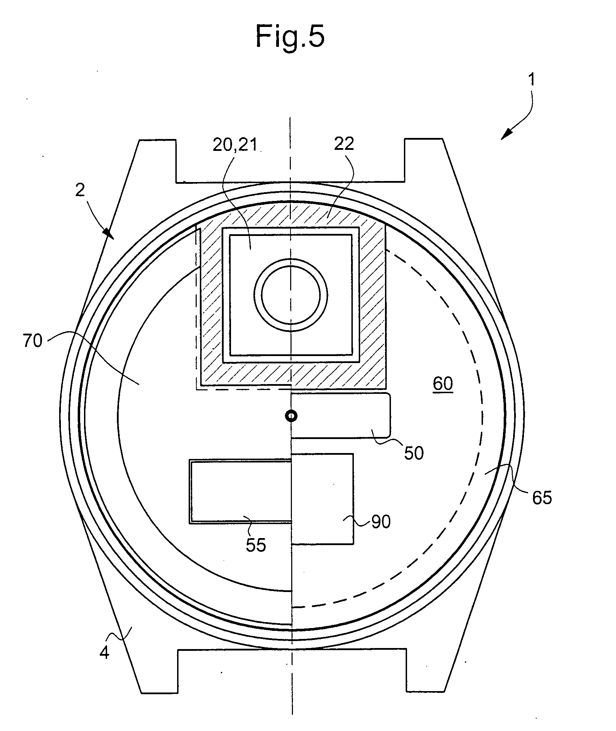

La figure 5 est une vue en plan similaire à la figure 1 dans laquelle la partie supérieure de l'instrument (lunette 7 et glace 3) ainsi qu'une partie du dispositif d'affichage 5 (aiguilles 51, 52 et cadran 53) n'ont pas été représentés. L'élément de support 70 et l'affichage digital 55 sont partiellement illustrés sur la partie gauche de la figure. Sur la partie droite de la figure, on peut encore voir partiellement le moteur 50 d'entraînement des aiguilles ainsi qu'un circuit 90 (par exemple un microcontrôleur horloger) également monté sur la partie supérieure de la plaquette de circuit imprimé 60 du module électronique 6. L'antenne 20 est illustrée ainsi que son plan de masse 22 dont la superficie plus importante est indiquée par les hachures. On notera qu'un dégagement est ménagé dans l'élément de support 70 pour accueillir l'antenne 20.

Dans le cadre de l'exemple de réalisation susmentionné, on aura donc compris que le plan de masse 22 de l'antenne microruban 20 est relié électriquement via la piste conductrice 65 directement à la partie électriquement conductrice de la boîte 2, à savoir le fond-carrure 4. Ceci assure un élargissement du plan de masse de l'antenne et ainsi une amélioration de la sensibilité de détection de l'antenne. Des tests pratiqués ont montrés qu'un gain de sensibilité significatif pouvait être attendu grâce à cette connexion à la partie électriquement conductrice de la boîte.

Dans ce qui précède, on a présenté une solution où l'antenne repose directement sur la plaquette de circuit imprimé. On comprendra que ceci n'est pas nécessairement le cas et que l'antenne pourrait être disposée selon d'autres configurations. A titre d'alternative, il est envisageable de disposer l'antenne et son plan de masse sur la lunette 7, à l'image de ce qui est proposé dans le document EP 1 274 150 A1, l'antenne étant alors recouverte par un élément de protection. Dans cette configuration, on notera que le plan de masse de l'antenne pourra avantageusement être formé d'une plaque de métal étampée possédant des pieds formant conducteur de masse et qui relient le plan de masse au module électronique. Une amélioration de la sensibilité de réception de l'antenne peut également être attendue dans cette configuration, dans la mesure où l'on assure, comme précédemment, une connexion électrique du plan de masse de l'antenne à la partie électriquement conductrice de la boîte via une piste conductrice ménagée en périphérie du module électronique 6. On rappellera qu'une telle connexion n'est pas prévue dans le document EP 1 274 150 A1.

On notera à nouveau que la présence d'une antenne comme décrit ci-dessus n'est pas une nécessité pour la mise en oeuvre de l'invention. Une simplification des connexions électriques ainsi que de l'assemblage de l'instrument peut être attendue d'une manière générale.

En effet, comme déjà mentionné dans le préambule, un potentiel électrique déterminé (potentiel de masse ou autre) est typiquement appliqué sur les parties électriquement conductrices de la boîte d'un tel instrument électronique porté au poignet. La présente invention permet d'assurer l'application d'un tel potentiel électrique déterminé sur la partie électriquement conductrice de la boîte par l'intermédiaire de la piste conductrice ménagée en périphérie de la plaquette de circuit imprimé, cette piste conductrice étant elle-même au potentiel électrique désiré. Dans ce cas, le potentiel électrique de la partie électriquement conductrice de la boîte est amené et établi par le biais du module électronique.

Selon une alternative, il est possible d'utiliser directement la partie électriquement conductrice de la boîte pour amener un potentiel électrique déterminé sur le module électronique. En particulier, l'un des pôles de la source d'énergie électrique pourrait être relié directement à la partie électriquement conductrice de la boîte et être amené par l'intermédiaire de cette dernière sur le module électronique via la piste conductrice ménagée en périphérie de la plaquette de circuit imprimé.

On comprendra de manière générale que diverses modifications et/ou améliorations évidentes pour l'homme du métier peuvent être apportées aux modes de réalisation décrits dans la présente description sans sortir du cadre de l'invention défini par les revendications annexées. En particulier, la présente invention n'est pas limitée, comme mentionné ci-dessus, à un instrument électronique porté au poignet comprenant une antenne. On aura toutefois compris que l'invention présente un avantage particulier dans le cadre d'un tel dispositif.

Concernant spécifiquement la question de l'antenne, on notera également que l'invention est applicable à tout type d'antenne munie d'un plan de masse, ceci incluant les antennes planaires en L ou F inversé (par ex. les antennes connues sous la dénomination PIFA - Planar Inverted-F Antenna).

## Revendications

1. Instrument électronique porté au poignet comprenant une boîte (2) dont une partie au moins (4) est électriquement conductrice et dans laquelle sont notamment logés un module électronique (6) comprenant une plaquette de circuit imprimé (60) et une source d'énergie électrique (10) pour alimenter ledit module électronique,
**caractérisé en ce que** ladite plaquette de circuit imprimé (60) présente, en périphérie, une zone de contact mécanique avec ladite partie électriquement conductrice (4) de la boîte (2),
et **en ce que** ladite plaquette de circuit imprimé (60) comporte une piste conductrice (65) s'étendant en périphérie de ladite plaquette de circuit imprimé, sur ladite zone de contact mécanique, et établissant un contact électrique avec ladite partie électriquement conductrice (4) de la boîte (2).

2. Instrument électronique selon la revendication 1, **caractérisé en ce qu'**il comporte en outre une antenne (20) munie d'un plan de masse (22) et **en ce que** ladite piste conductrice (65) connecte électriquement ledit plan de masse (22) de l'antenne (20) à ladite partie électriquement conductrice (4) de la boîte (2).

3. Instrument électronique selon la revendication 2, **caractérisé en ce que** ladite antenne (20) est une antenne microruban comprenant un élément radiant (21) disposé sensiblement parallèlement au dit plan de masse (22).

4. Instrument électronique selon la revendication 3, **caractérisé en ce que** ladite antenne (20) est reliée électriquement à une face supérieure de ladite plaquette de circuit imprimé (60) du côté d'un dispositif d'affichage (5) de l'instrument électronique.

5. Instrument électronique selon l'une quelconque des revendications 1 à 4, **caractérisé en ce qu'**il comporte un ruban électriquement conducteur (45) en matériau compressible qui est interposé, sur ladite zone de contact mécanique, entre ladite partie électriquement conductrice (4) de la boîte (2) et ladite piste conductrice (65).

6. Instrument électronique selon la revendication 5, **caractérisé en ce que** ledit ruban électriquement conducteur (45) est comprimé entre ladite piste conductrice (65) et un épaulement (40) ménagé sur la partie électriquement conductrice (4) de la boîte (2).

7. Instrument électronique selon la revendication 6, **caractérisé en ce qu'**il comporte en outre un élément de support (70, 75) exerçant un appui en plusieurs points de la périphérie de ladite plaquette de circuit imprimé (60) où est comprimé ledit ruban électriquement conducteur (45).

8. Instrument électronique selon la revendication 5, 6 ou 7, **caractérisé en ce que** ledit ruban électriquement conducteur (45) est un élastomère conducteur.

9. Instrument électronique selon l'une quelconque des revendications précédentes, **caractérisé en ce que** ladite piste conductrice (65) est disposée sur une première face de la plaquette de circuit imprimé (60) et est reliée électriquement à d'autres pistes conductrices du module électronique (6) par le biais de trous métallisés (80).

10. Instrument électronique selon l'une quelconque des revendications précédentes, **caractérisé en ce que** ladite partie électriquement conductrice (4) de la boîte (2) est reliée électriquement à un pôle de potentiel électrique déterminé de la source d'énergie électrique (10), ladite partie électriquement conductrice (4) de la boîte (2) servant à amener ledit potentiel électrique déterminé sur ledit module électronique (6) par l'intermédiaire de ladite piste conductrice (65).

11. Instrument électronique selon l'une quelconque des revendications 1 à 9, **caractérisé en ce que** ladite partie électriquement conductrice (4) de la boîte (2) est amenée à un potentiel électrique déterminé par l'intermédiaire de ladite piste conductrice (65).

12. Instrument électronique selon l'une quelconque des revendications précédentes, **caractérisé en ce que** ladite piste conductrice (65) s'étend sur essentiellement toute la périphérie de la plaquette de circuit imprimé (60).

13. Instrument électronique selon l'une quelconque des revendications 1 à 11, **caractérisé en ce que** ladite piste conductrice (65) s'étend sur une partie de la périphérie de la plaquette de circuit imprimé (60).
